# EUROPEAN PATENT SPECIFICATION

(11) **EP 2 385 544 B1**
(45) Date of publication and mention of the grant of the patent: **13.02.2013**
(21) Application number: 10196883.2
(22) Date of filing: 23.12.2010
(51) Int. Cl.: H01L 21/335, H01L 29/778, H01L 29/423, H01L 29/40

(54) **Methods for manufacturing enhancement-mode HEMTs with self-aligned field plate**
Verfahren zur Herstellung von Verstärkungsmodus-HEMTs mit selbstausgerichteter Feldplatte
Procédés de fabrication d'HEMT à mode d'enrichissement avec plaque de champ auto-alignée

(30) Priority: 23.12.2009 US 289553 P; 24.06.2010 US 823060
(43) Date of publication of application: 09.11.2011
(73) Proprietor: Intersil Americas Inc., Milpitas, CA 95035 (US)
(72) Inventor: Hebert, Francois, San Mateo, CA 94402 (US)
(74) Representative: Fleuchaus, Michael A.

(56) References cited:
- US-A1- 2006 006 414
- US-A1- 2008 203 430
- US-A1- 2008 238 844
- US-B1- 7 560 325

## Description

### Cross Reference to Related Application

This application claims the benefit of U.S. Provisional Patent Applications Serial Nos. 61/219,995 filed June 24, 2009; 61/259,399 filed November 9, 2009; and 61/289,553 filed December 23, 2009.

### Technical Field to which the Invention Relates

The present application relates to integrated circuits. In particular, the application pertains to enhancement-mode high electron mobility transistors with a self-aligned field plate.

### Background

Many high-performance structures are normally "on" in a "depletion-mode" of operation, which is ill suited for power applications like DC to DC converters. For power applications, some "enhancement-mode" or "normally off" structures have been proposed, however, the performance and reliability of the enhancement mode structures are inferior to the structures of conventional depletion mode structures.

US 2006/006414 discloses embodiments to stabilize the surface of GaN field-effect devices prior to surface contamination by air exposure and damage through different processing steps, in order to increase electron density in a channel and have a high performance device that can be reliably produced.

US 2008/203430 discloses a reliable enhancement mode insulated gate double heterostructure field-effect transistor that has low power consumption at zero gate bias with low gate currents.

US 7560325 discloses the formation of selective epitaxial through openings in a regrowth mask material to form the gate or the source/drain regions of the device. The device can be made from a wide band-gap semiconductor material such as SiC. The regrowth mask material can be TaC.

US 2008/238844 discloses a liquid crystal driver circuit that includes a timing controller emitting at least two control signals therefrom, and at least two gate drivers receiving the control signals from the timing controller.

### Summary of the invention

The invention relates to methods for manufacturing enhancement-mode HEMTs as defined in the appended claims.

### Description of Embodiments

The accompanying drawings, which are incorporated in and constitute a part of this specification, illustrate embodiments of the present teachings and together with the description, serve to explain the principles of the present disclosure. In the figures:

FIGS. 1-13 are cross sections of various manufacturing steps of enhanced mode (e-mode) high electron mobility transistors (HEMTs), according to embodiments of the present teachings;

FIG. 14 is a cross section of a cap structure that can be used in the manufacturing of the e-mode HEMTs, according to embodiments of the present teachings;

FIGS. 15-23 are cross sections of various manufacturing steps of e- mode HEMTs including the cap structure of FIG. 14, according to embodiments of the present teachings; and

FIGS. 24-41 are cross sections of various manufacturing steps of e- mode HEMTs including AlN, according to embodiments of the present teachings.

It should be noted that some details of the FIGS. have been simplified and are drawn to facilitate understanding of the inventive embodiments rather than to maintain strict structural accuracy, detail, and scale. It should also be noted that not all manufacturing steps are illustrated, as the general methods of semiconductor manufacturing are well known.

Reference will now be made in detail to the present embodiments (exemplary embodiments) of the present teachings, examples of which are illustrated in the accompanying drawings. Wherever possible, the same reference numbers will be used throughout the drawings to refer to the same or like parts.

Various embodiments of the disclosure include the formation of enhancement-mode (e-mode) gate injection high electron mobility transistors (HEMT). Embodiments can include compound semiconductor (e.g., GaN, AlGaN, InAlN, InP, InGaAs, InAlAs, etc.) based HEMTs. Embodiments also can include self-aligned P-type gate and field plate structures. The gates can be self-aligned to the source and drain, which can allow for precise control over the gate-source and gate- drain spacing. Additional embodiments include the addition of a GaN cap structure, an AlGaN buffer layer, AlN, recess etching, and/or using a thin oxidized AlN layer (or other insulator). In manufacturing the HEMTs according to present teachings, selective epitaxial growth (SEG) and epitaxial lateral overgrowth (ELO) can both be utilized to form gates.

As used herein, SEG can include using various epitaxial processes, e.g., Metal Organic Chemical Vapor Deposition (MOCVD), molecular beam epitaxy (MBE), etc., to grow an epitaxial layer from a seed point without nucleating additional growth sites. As used herein, ELO can include the growth of an epitaxial layer that grows equally in all directions, i.e., both laterally and vertically. Further, while the following exemplary embodiments discuss specific semiconductor layers, it will be understood that any known compound semiconductor (e.g., III-V, II-VI, etc.) can be used, including binary compound semiconductors, e.g., GaN, AlN, GaAs, InP, InAs, etc., ternary compound semiconductors, e.g., AlGaN, InAlN, AlGaAs, InGaN, InAlAs, InGaAs, etc., and quaternary compound semiconductors, e.g., AlGaInP, etc. It will also be understood that to manufacture the presently taught e-mode HEMTs, these compound semiconductors can be layered and/or stacked in various combinations. As will be understood, the following description of the various processes can include additional steps based on the semiconductor manufacturing process being used. As will also be understood, the parameters of each process step can vary according to the equipment used and the desired layer. As will be understood, P-type devices (N- channel with P-gate) are specifically discussed, however N-type devices can also be used.

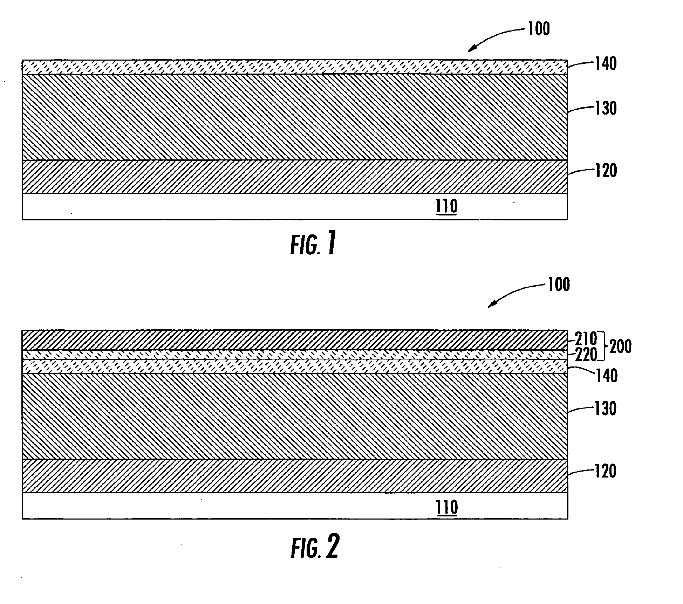

In one exemplary process depicted in FIGS. 1-13, a process for forming a GaN/AlGaN e-mode HEMT 100 is shown. In other embodiments, the AlGaN can be replaced by other III-V semiconductors, for example, InAlN to form a GaN/InAlN e-mode HEMT.

In FIG. 1, a substrate 110, for example, Si, Sapphire, Silicon on diamond (SOD), diamond, Silicon Carbide (SiC), etc., is shown over which a buffer layer or layers 120 has been formed. The substrate 110 can have a crystal orientation, e.g., c-axis if Sapphire, or <111> if Si, and the buffer layers 120 can be, for example, GaN/AlN, AlGaN, AlGaN/AlN, etc. The buffer layers 120 can have varying thicknesses of about hundreds to about thousands of angstroms, and can be formed by various well known epitaxial growing techniques. Over the buffer layers 120 a layer of GaN 130 can be grown or in other embodiments the GaN layer 130 can be included as part of the buffer layers 120. The GaN layer 130 can be undoped (intrinsic) or N-type, and have a thickness of about 0.5 microns to greater than about 2 microns depending on the application. For example, low-voltage RF power applications will most likely use a thinner GaN layer than high-voltage power conversion applications. AlGaN 140 can be grown over the GaN layer 130, and can be about 10% to about 28% Al (about 25% preferred) and undoped. The AlGaN layer 140 can have a thickness of about 150Å to about 300Å, with about 250Å preferred (the thickness of the AlGaN layer can impact the channel charge and the pinch-off voltage of depletion mode devices). As will be understood, the above layers can be formed by conventional methods, including epitaxial growth, e.g., MOCVD, molecular beam epitaxy (MBE), etc. Following the growth of the AlGaN layer 140, known techniques for device isolation (e.g., implant and anneal) can be performed.

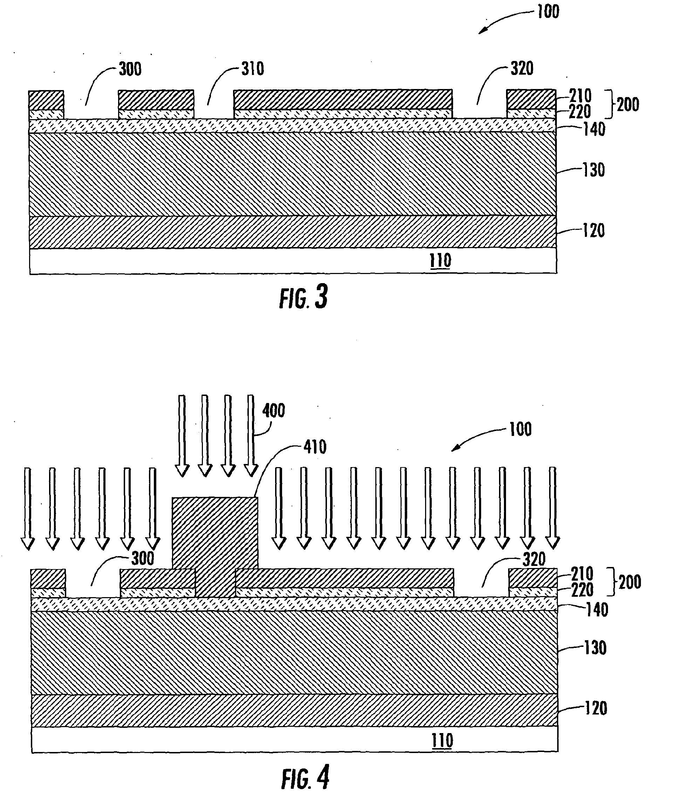

In FIG. 2, a dielectric stack 200 can then be deposited using known oxide and nitride deposition techniques, for example, low pressure chemical vapor deposition (LPCVD), plasma enhanced CVD (PECVD), atmospheric CVD (ACVD), sub-atmospheric CVD (SACVD), atomic layer deposition (ALD), etc. Although oxides and nitrides are specifically mentioned, other materials may be appropriate depending on the application, such as oxy-nitrides, silicon-rich oxides, non-silicon based oxides, etc. The dielectric stack 200 can include one or more dielectric layers, for example, a first dielectric layer 220 including, e.g., nitride, oxide, oxynitride, etc., and a second dielectric layer 210 including an undensified oxide. The dielectric stack 200 can be blanket deposited over the AlGaN layer 140. The dielectric stack 200 can be patterned by, for example, a contact mask (not shown) that can be used to define a source contact area 300, a gate contact area 310, and a drain contact area 320, as shown in FIG. 3. An advantage to this process is that a single masking step is used to self-align the gate contact area to the source contact area 300 and the drain contact area 320. By using a single masking step, precise control of the gate-source and gate-drain spacing can be obtained, which can reduce On- Resistance of the drain to source (Rdson) and breakdown voltage of the drain to source with the gate shorted to the source (BVdss) variations. The resulting structure is shown in FIG. 3, in which the three defined areas (300, 310, 320) can be etched to remove the dielectric stack 200 to expose a surface of the AlGaN layer 140. Etching techniques such as plasma etching, reactive ion etching (RIE), magnetically enhanced RIE (MERIE), inductively coupled plasma (ICP), transformer coupled plasma (TCP), wet etching, chemical mechanical polishing (CMP), etc., can be used. It will be understood the various etching techniques can be used to isotropically and/or anisotropically etch a given material and that the selectivity of a given etch technique can depend on the material being etched and the chemical composition of the etchants.

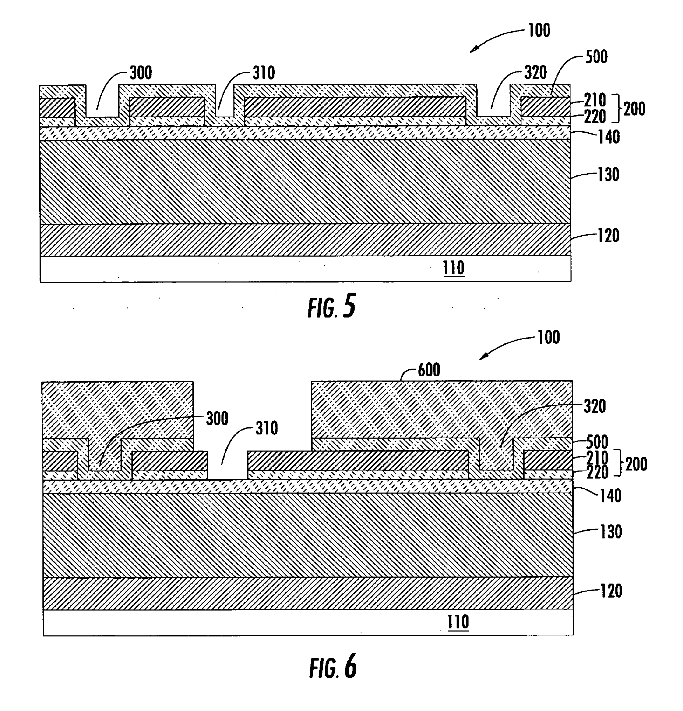

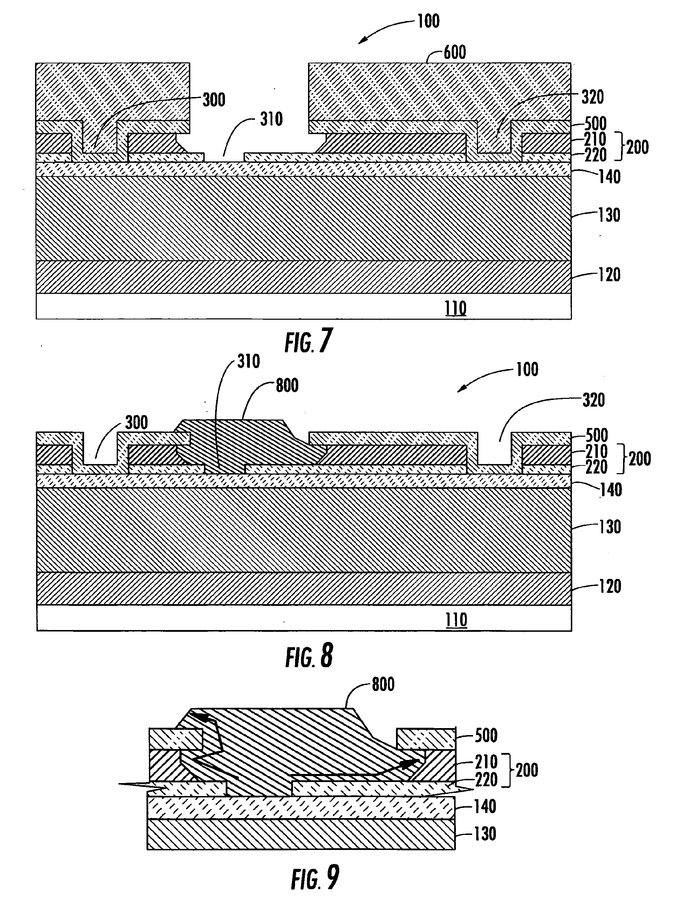

FIG. 4 shows an optional gate protection mask 410 that can be used during an optional N+ implant 400. A resist strip can be performed to remove the gate protection mask 410 after the implant, and an anneal at about 1100oC to about 1300oC in nitrogen ambient can be performed to further drive in the N+ implant. In FIG. 5, a dielectric layer 500 (e.g., plasma silicon nitride) can be deposited conformally over the patterned dielectric stack 200 and the exposed portions of the AlGaN layer 140. The nitride can be deposited using LPCVD or PECVD. As shown in FIG. 6, a mask 600 can be formed and used to expose the defined gate contact area 310. A first dry etch (preferably anisotropic) can be used to selectively etch the dielectric layer 500 in the defined gate contact area 310. The first dry etch can be selective to AlGaN and the dielectric stack 200. Following the first dry etch, a second isotropic etch of layer 210, selective to layers 220, the AlGaN layer 140, and the dielectric layer 500 can be performed. The second etch can also etch the dielectric layer 210 at a faster rate to provide under-cutting of dielectric 210 under the dielectric layer 500. Various types of etching can be used, for example, HF, a buffered oxide etchant (BOE) bath, isotropic dry etching using a downstream plasma etch technique, etc. The resulting structure is shown in FIG. 7, which shows the gate contact area 310 including an exposed portion of the AlGaN layer 140 having approximately straight sidewalls formed from the dielectric layer 220 and an approximately wider bowl shaped area formed in the dielectric layer 210, with under- cutting under the dielectric layer 500.

Next, the masking layer 600 can be removed and wafer cleaning can be performed. Following the cleaning, selective epitaxial growth of P-type AlGaN can be performed. As shown in FIGS. 8-9, P-type AlGaN 800 is grown in the gate contact area 310. The epitaxial growth includes lateral overgrowth as shown so that the P-type AlGaN 800 substantially fills the available space formed by the previous etching steps. The P-type AlGaN 800 can be grown from the exposed AlGaN layer 140 (which can be used as a seed region) in gate contact area 310. The P-type AlGaN 800 grows equally vertically and laterally from gate contact area 310, thereby forming/filling the shape left by the previous etches. The epitaxial growth can be performed at temperatures in the range of about 1000°C to about 1150°C, with NH3, Cp2Mg, TMGa, TMAI, etc. having flow rates adjusted to get growth rates of about 0.5 nm/sec to about 10 nm/sec, and an aluminum concentration of about 10% to about 25%. Other gas sources can also be used.

As will be understood, many different shapes can be formed by the AlGaN 800 depending on the type and length of the previous etching steps and the shape shown in FIGS. 8-9 is not intended to be limiting. In addition, as shown, the P-type AlGaN 800 forms the gate for the e-mode HEMT 100. Also, the portion of the P-type AlGaN gate 800 that is closer to the drain contact area 320 and appears to overhang the dielectric layer 220 can act as a field plate in the finished e-mode HEMT 100. Field plates can reduce peak electric fields around the source and drains of the e-mode HEMT.

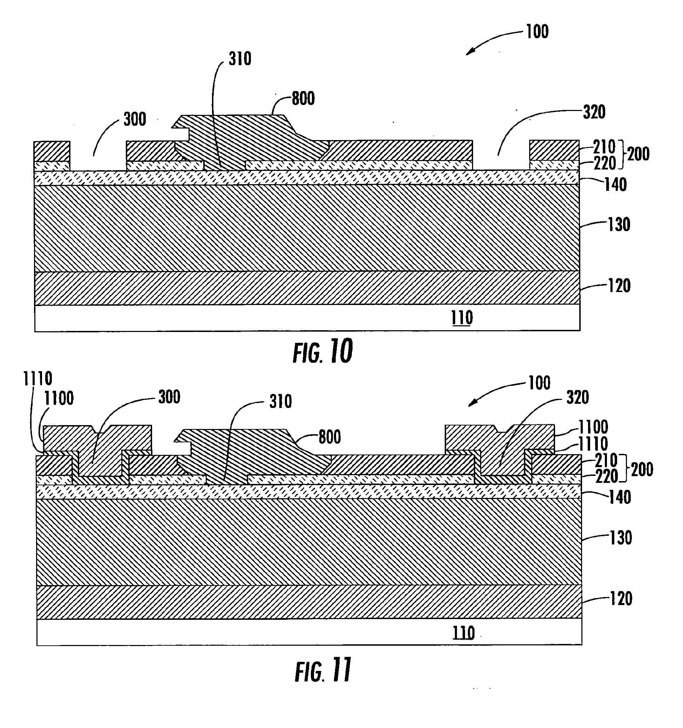

After the P-type AlGaN 800 is grown, the dielectric 500 can be removed by, e.g., isotropic etching, resulting in the structure shown in FIG. 10. As shown in FIG. 11, ohmic metal contacts 1100, 1110 can be formed in the source contact area 300 and in the drain contact area 320. The ohmic metal contacts 1100, 1110 can be formed from various metal layers, for example, Ti/Al/Ni/Au, Ti/Al, etc. In one embodiment for forming the ohmic metal contacts 1100, 1110, a resist mask can be used, a metal stack deposited, the resist mask stripped, and an anneal of the deposited metal stack performed. In an alternative embodiment, a blanket metal deposition can be performed, a metal mask can be used as a guide for a metal etch followed by a resist strip and anneal. Either method can be used to form the ohmic contacts shown in FIG. 11.

Similarly, various methods can be used to deposit the Schottky metal 1200, 1210 over the P-type AlGaN gate 800. In one embodiment, a gate resist mask can be used, followed by Schottky gate metal deposition (e.g., Ni, Au, Pd, etc.), resist strip and an anneal. Alternatively, a blanket gate metal deposition can be performed, then using a gate metal mask and metal etch the gate metal 1200, 1210 can be formed. The gate metal mask can be stripped and the remaining gate metal annealed. In another embodiment, optional blanket dielectric deposition and masking steps can be used prior to the gate metal deposition. The gate metal 1200, 1210 can also form field plates and/or act as double step field plates for the P-type gate 800. The gate metal 1200, 1210 can also be formed in various different shapes to enhance the effect of the field plates.

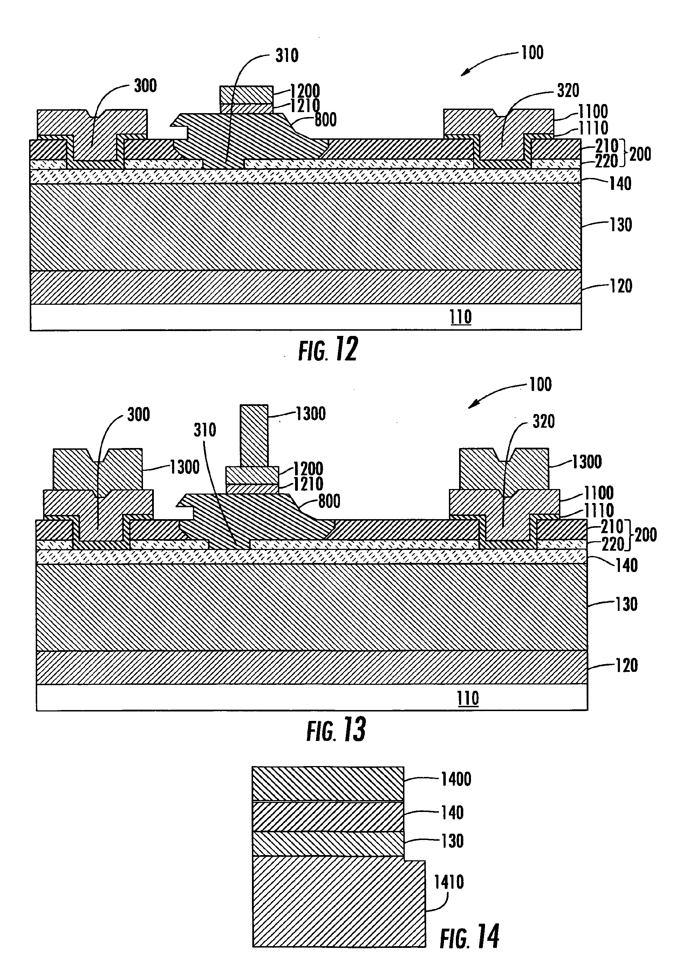

Finally, as shown in FIG. 13, electrode metal 1300 can be deposited and etched (or vice a versa) to form interconnect metal 1300, after optional dielectric isolation between the metal layers (inter metal dielectric, not shown). In embodiments, the interconnect metal 1300 can form an overhang (not shown) from source contact area 300 to gate contact area 310. This overhang area can also act as a field plate (e.g., source connected field plate). Additional steps can include passivation processes, pad masking and etch, top metal interconnection, and final alloying, as are well known in the semiconductor manufacturing art.

As discussed above and will be appreciated, the AlGaN can be replaced by InAlN or various other III-V semiconductors, including binary III-V semiconductors and tertiary III-V semiconductors, for example, presently taught embodiments can include GaN/InAlN/P-type InAlN HEMTs.

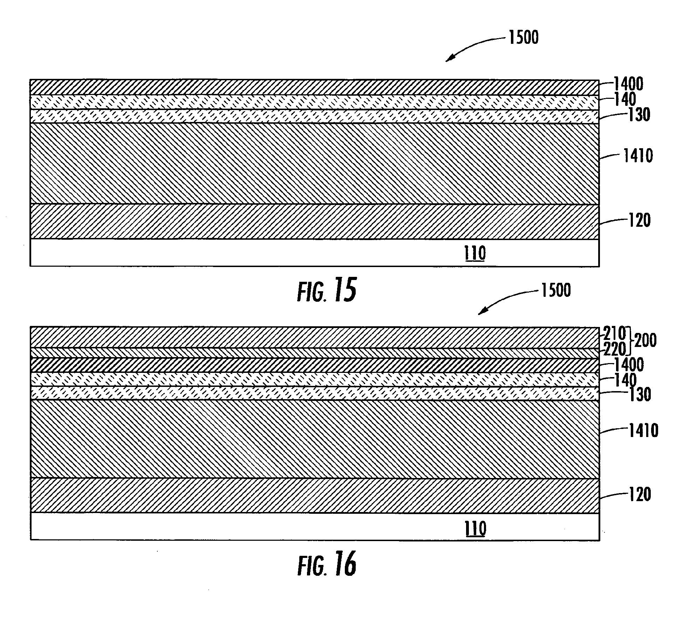

FIG. 14 shows a focused view of the cap layer 1400 and the heterostructure. FIGS. 15-23 show another presently taught embodiment of an e- mode HEMT 1500 including a GaN cap layer 1400 over the AlGaN/GaN heterostructure discussed with reference to FIGS. 1-13. Also included is an AlGaN layer 1410 between the buffer layers 120 and the GaN layer 130, which as discussed above, can be part of the buffer layers 120.

FIG. 14 shows the double two dimensional electron gas (2DEG) structure including an AlGaN layer 1410, a GaN layer 130, an AlGaN layer 140, and a cap layer of GaN layer 1400. The AlGaN layer 1410 can have a low Al content of about 1% to about 6%. The AlGaN layer 140 can have about 20% to about 27% Al. As shown in FIG. 15, this structure can be formed over buffer layers 120, which can be formed over substrate 110 as discussed above. Similar to the method discussed above, the various semiconductor layers (1410, 130, 140, and 1400) can be grown as epitaxial layers using, e.g., MOCVD, MBE, etc.

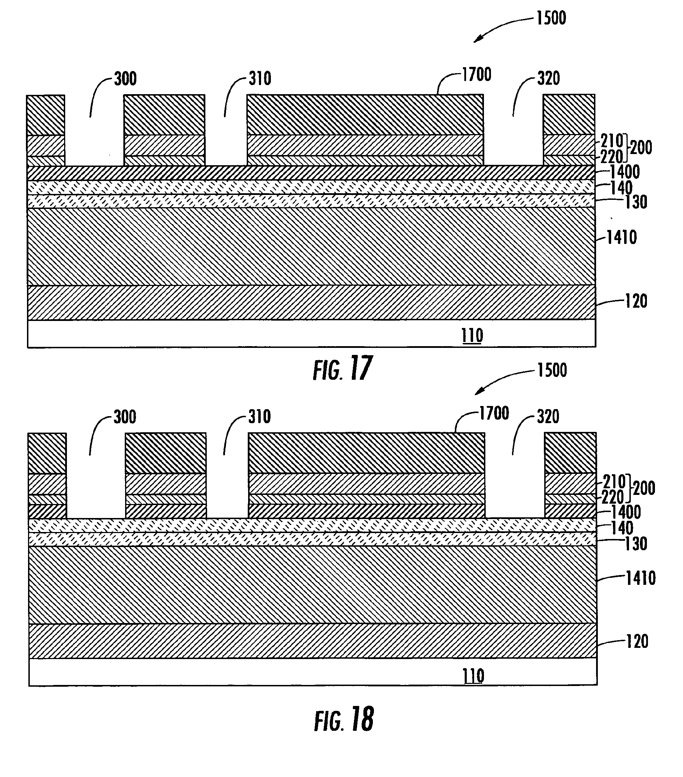

Following the growth of the double 2DEG structure, dielectric stack 200 can be formed by deposition. As discussed above, dielectric stack 200 can include one or more dielectric layers, for example, a first dielectric layer 220 including, e.g., nitride, oxide, oxynitride, etc., and a second dielectric layer 210 including an undensified oxide. The dielectric stack 200 can be blanket deposited over the GaN layer 1400. As shown in FIG. 17, the dielectric stack 200 can be patterned by, for example, a contact mask 1700, that defines a source contact area 300, a gate contact area 310, and a drain contact area 320. An advantage to this process is that a single masking step is used to self-align the gate contact area to the source contact area 300 and the drain contact area 320. The three defined areas can be etched to remove the dielectric stack 200 to expose a surface of the GaN layer 1400. Etching techniques such as plasma etching, reactive ion etching (RIE), magnetically enhanced RIE (MERIE), inductively coupled plasma (ICP), transformer coupled plasma (TCP), wet etching, chemical mechanical polishing (CMP), etc., can be used.

Following the dielectric stack 200 etch, the same contact mask 1700 can be used to further etch the GaN layer 1400 to expose the AlGaN layer 140 in the source contact area 300, the gate contact area 310, and the drain contact area 320. The GaN layer 1400 etch can be an anisotropic dry etch using inductively coupled plasma (ICP) or other dry etch technique, and/or various photo-enhanced etching techniques, e.g., photochemical wet etch, that are selective to the AlGaN layer 140 and to the dielectric stack 200.

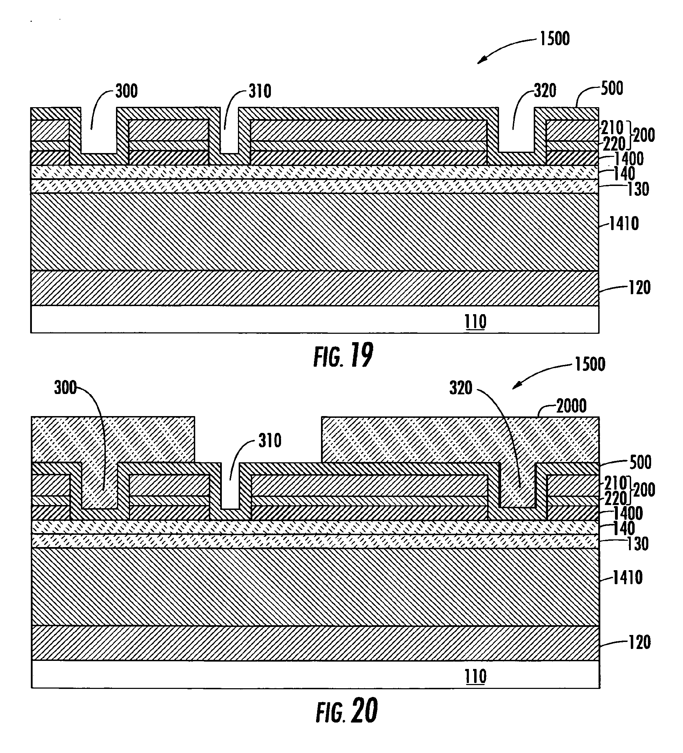

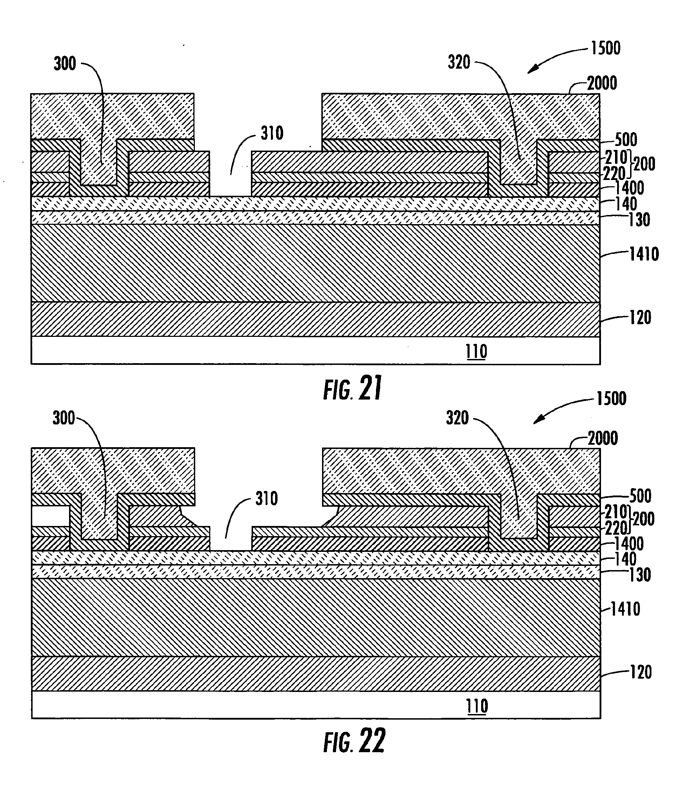

In FIG. 19, a dielectric layer 500 (e.g., plasma silicon nitride) can be deposited conformally over the patterned dielectric stack 200 and the exposed portions of the AlGaN layer 140. The nitride can be deposited using LPCVD or PECVD. As shown in FIG. 20, a mask 2000 can be formed to expose the defined gate contact area 310. A first dry etch (preferably anisotropic, but some lateral etching can also be acceptable) can be used to selectively etch the dielectric layer 500 in the defined gate contact area 310. The first dry etch can be selective to AlGaN, GaN layer 1400, and the dielectric stack 200. Following the first dry etch, a second etch that is selective to dielectric layer 220, GaN layer 1400, AlGaN layer 140, and the dielectric layer 500 can be performed. Various types of isotropic etching can be used, for example, HF, buffered oxide etchant (BOE) bath, isotropic dry etching using a downstream plasma etch technique, etc. The resulting structure is shown in FIG. 22, which shows the gate contact area 310 including an exposed portion of the AlGaN layer 140 having approximately straight sidewalls formed from the GaN layer 1400 and dielectric layer 220, and an approximately wider bowl shaped area formed in the dielectric layer 210, with under-cutting under the dielectric layer 500.

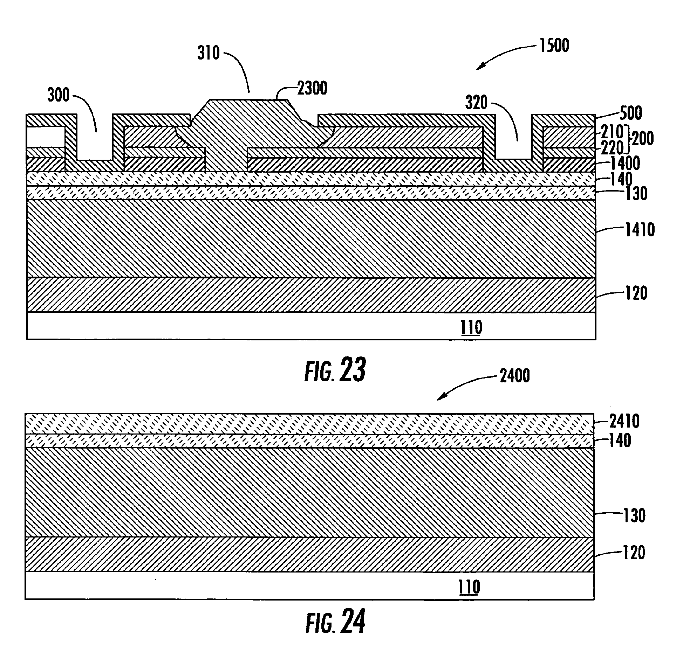

Next, the masking layer 2000 can be removed and a wafer cleaning can be performed. Following the cleaning, GaN selective epitaxial growth of P-type AlGaN can be performed. As shown in FIG. 23, P-type AlGaN 800 can be grown in the gate contact area 310. The epitaxial growth includes lateral overgrowth as shown so that the P-type AlGaN 800 substantially fills the available space formed by the previous etching steps. The P-type AlGaN 800 can be grown from the exposed AlGaN layer 140 (which can be used as a seed region) in gate contact area 310. The P-type AlGaN 800 grows equally vertically and laterally from gate contact area 310, thereby forming/filling the shape left by the previous etches. The e-mode HEMT 1500 can be further processed as discussed above, including but not limited to, electrode formation, passivation, pad formation, etc.

FIGS. 24-32 show another embodiment of an e-mode HEMT 2400 including an AlN semiconductor layer 2410. The e-mode HEMT 2400 is manufactured by similar processes as those discussed above.

In FIG. 24, a substrate 110, for example, Si, Sapphire, Silicon on diamond (SOD), diamond, SiC, etc., is shown over which a buffer layer or layers 120 can be formed. The substrate 110 can have a crystal orientation, e.g., c-axis if Sapphire, <111> if Si. The buffer layers 120 can be, for example, GaN/AlN, AlGaN, AlGaN/AlN, etc. Over the buffer layers 120 a layer of GaN 130 is shown. The GaN layer 130 can be undoped. AlGaN 140 can be formed over the GaN layer 130, which can be about 10% to about 28% Al and undoped. Over the AlGaN layer 140, an AlN layer 2410 can be formed. The AlN layer 2410 can be grown in-situ to control quality and the crystal interface. A surface pre-treatment prior to the in-situ AlN deposition can also be performed in order to obtain an AlN layer with the appropriate structure. The pre-treatment can include nitridation of the exposed surface (e.g., by exposing the surface to ammonia at elevated temperatures, e.g., greater than about 500oC). The AlN layer 2410 can also protect the device layers. Following the growth of the AlGaN layer 140, known techniques for device isolation (e.g., implant and anneal) can be performed.

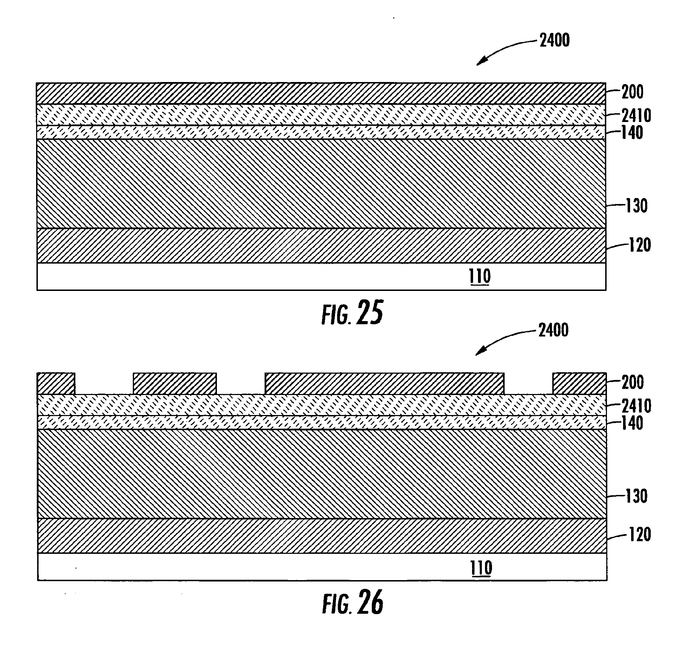

FIG. 25 shows a dielectric stack 200 deposited over the AlN layer 2410. The dielectric stack 200 can be one or more dielectric layers. In the Embodiment shown, a single layer undensified oxide is used. The dielectric stack 200 can be blanket deposited over the AlN layer 2410. As shown in FIG. 26, the dielectric stack 200 can be patterned by, for example, a contact mask (not shown), that can be used to define a source contact area 300, a gate contact area 310, and a drain contact area 320. An advantage to this process is that a single masking step is used to self-align the gate contact area to the source contact area 300 and the drain contact area 320. The resulting structure is shown in FIG. 26, in which the three defined areas can be etched to remove the dielectric stack 200 to expose a surface of the AlN layer 2410.

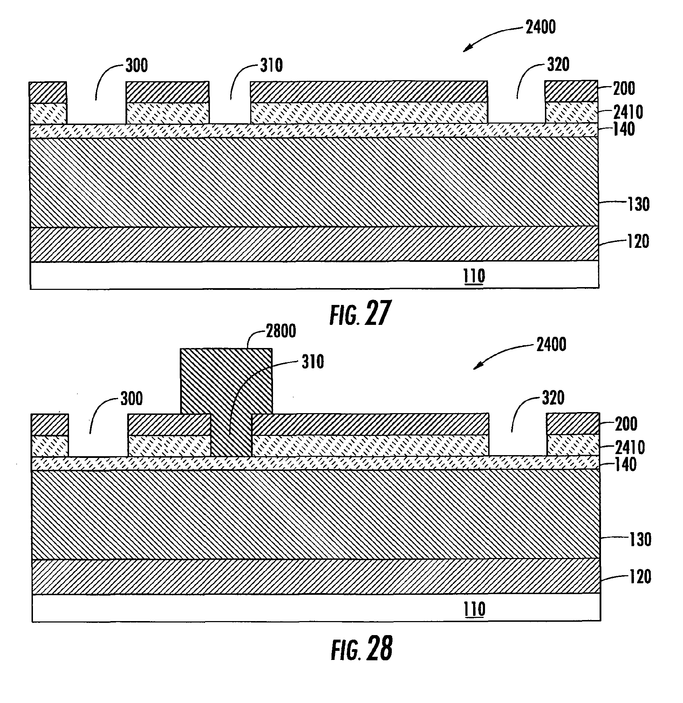

In FIG. 27, the etched dielectric stack 200 is used as a masking layer for etching the AlN layer 2410 in the source contact area, the gate contact area, and the drain contact area to expose the AlGaN layer 140. The AlN layer 2410 etch can be a selective etch to AlGaN layer 140 and to dielectric stack 200. Potassium hydroxide (KOH) and similar etchants can be used for this step, such as, ICP dry etch, or photo enhanced chemical etching techniques.

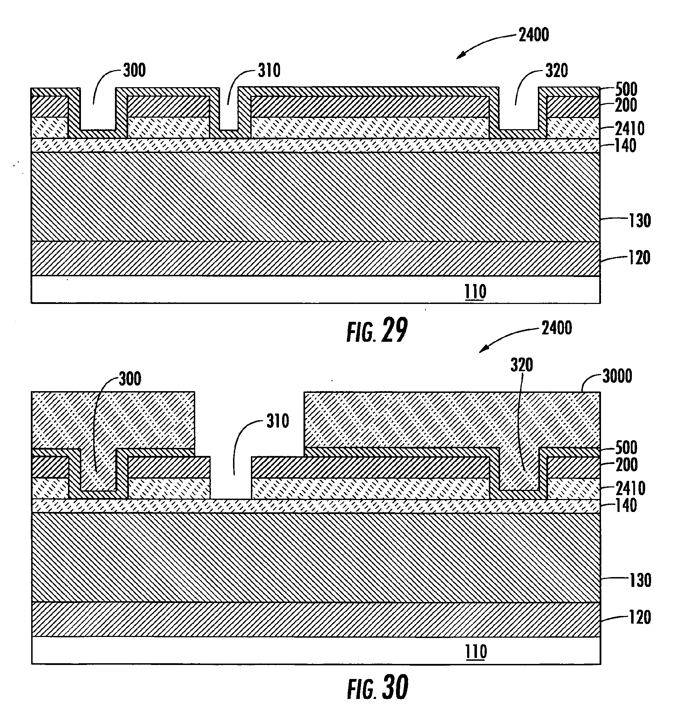

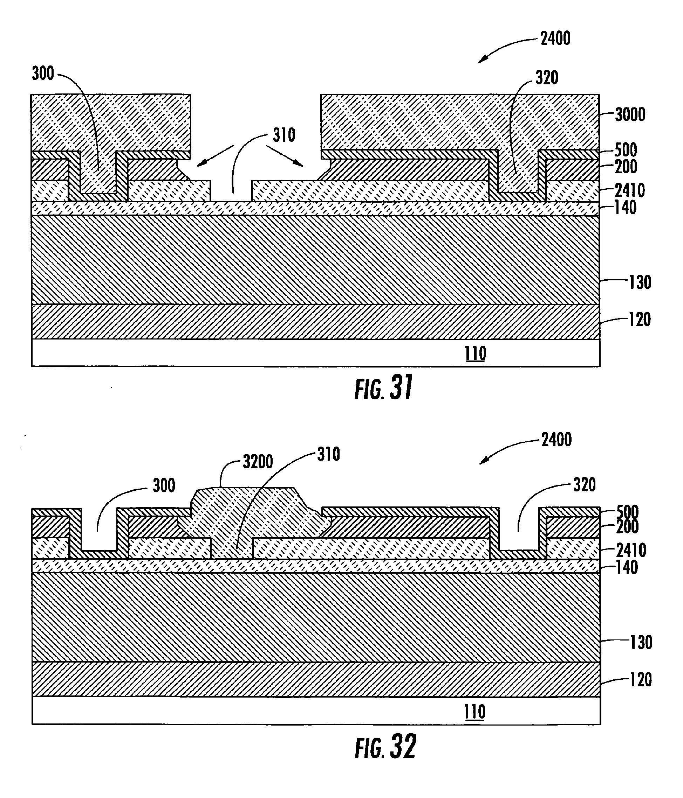

FIG. 28 shows an optional gate protection mask 2800, which an optional N+ implant (not shown) process can use to protect the gate contact area 310. A resist strip can be performed to remove the gate protection mask 2800 and an anneal at about 1100oC to about 1300oC in nitrogen ambient can be performed to further drive in the N+ implant. In FIG. 29, a dielectric 500 (e.g., plasma silicon nitride) can be deposited conformally over the patterned dielectric stack 200 and the exposed portions of the AlGaN layer 140. The nitride can be deposited using LPCVD. As shown in FIG. 30, a resist mask 3000 can be used to expose the defined gate contact area 310 for further etch. A first dry etch can be used to selectively etch the dielectric layer 500 in the defined gate contact area 310. The first dry etch can be selective to AlGaN, AlN, and the dielectric stack 200. Following the first dry etch, a second etch that is selective to the dielectric layer 500, the AlN layer 2410, and the AlGaN layer 140 can be performed. The resulting structure is shown in FIG. 31, which shows the gate contact area 310 including an exposed portion of the AlGaN layer 140 having approximately straight sidewalls formed from the AlN layer 2410 and an approximately wider bowl shaped area formed in the dielectric stack 200, with under-cutting under the dielectric layer 500.

Next, the masking layer 3000 can be removed and a wafer cleaning can be performed. Following the cleaning, selective epitaxial growth of P-type AlGaN can be performed. As shown in FIG. 32, P-type AlGaN 3200 can be grown in the gate contact area 310. The epitaxial growth can include lateral overgrowth as shown so that the P-type AlGaN 3200 substantially fills the available space formed by the previous etching steps. The P-type AlGaN 3200 can be grown from the exposed AlGaN layer 140 (which can be used as a seed region) in gate contact area 310. The P-type AlGaN 3200 can grow equally vertically and laterally from gate contact area 310, thereby forming/filling the shape left by the previous etches.

As will be understood, many different shapes can be formed by the AlGaN 3200 depending on the type and length of the previous etching steps and the shape shown in FIG. 32 is not intended to be limiting. In addition, as shown, the P- type AlGaN 3200 forms the gate for the e-mode HEMT 2400. Also, the portion of the P-type AlGaN gate 3200 that is closer to the drain contact area 320 and appears to overhang the dielectric stack 200 can act as a field plate in the finished e-mode HEMT 2400. Field plates can reduce peak electric fields around the source and drains of the e-mode HEMT.

While the following steps are not illustrated, they are similar to the steps described above with reference to FIGS. 10-13. After the P-type AlGaN 3200 is grown, the dielectric 500 can be removed by, e.g., isotropic etching. Next, ohmic metal contacts can be formed in the source contact area 300 and in the drain contact area 320. The ohmic metal contacts can be formed from various metal layers, for example, Ti/Al/Ni/Au, Ti/Al, etc. In one embodiment for forming the ohmic metal contacts, a resist mask can be used, a metal stack deposited, the resist mask stripped, and an anneal of the deposited metal stack performed. In an alternative embodiment, a blanket metal deposition can be performed, a metal mask can be used as a guide for a metal etch followed by a resist strip and anneal. Either method can be used to form the ohmic contacts.

Similarly, various methods can be used to deposit Schottky gate metal over the P-type AlGaN gate 3200. In one embodiment, a gate resist mask can be used, followed by gate metal deposition (e.g., Ni, Au, Pd, etc.), resist strip and an anneal. Alternatively, a blanket gate metal deposition can be performed, then using a gate metal mask and metal etch the gate metal can be patterned. The gate metal mask can be stripped and the remaining Schottky metal annealed. In another embodiment, optional blanket dielectric deposition and masking steps can be used prior to the Schottky gate metal deposition. The gate metal can also form field plates and/or act as a double step field plates for P-type gate 3200. The gate metal can also be formed in various different shapes to enhance the effect of the field plates.

Finally, electrode metal can be deposited and etched (or vice a versa) to form interconnect metal. In embodiments, the interconnect metal can form an overhang from source contact area 300 to gate contact area 310. This overhang area can also act as a field plate. Additional steps can include passivation processes, pad masking and etch, top metal interconnection, and final alloying, as are well known in the semiconductor manufacturing art.

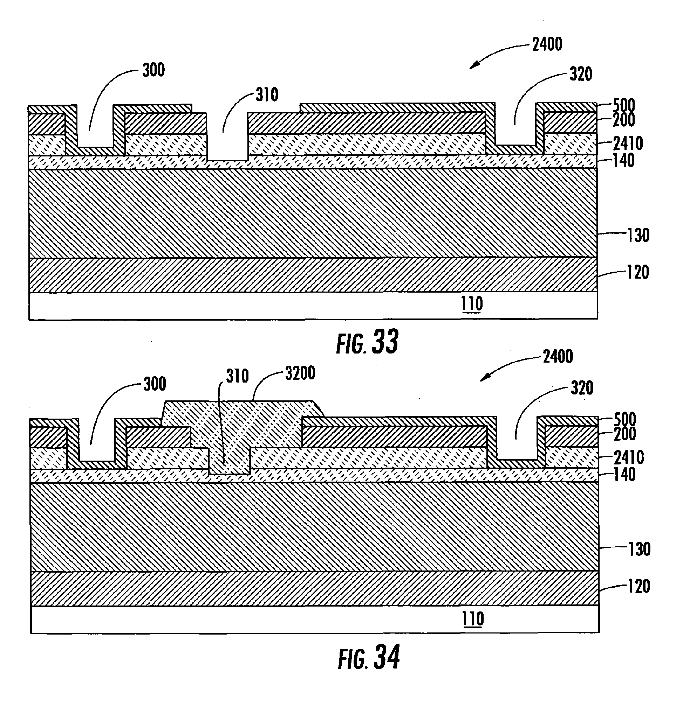

In alternative embodiments of the e-mode HEMT 2400, following the AlN layer 2410 etch, a recess can be etched into the AlGaN to form a recessed P- gate structure as shown in FIG. 33. This recess etch can be performed to a depth of typically a fraction of the AlGaN thickness (about 5% to about 75%), depending on the device characteristics desired for the application, and can also be performed in the above discussed processes. Additional recess etches can also be performed in the source contact area and the drain contact area. FIG. 34 shows the resulting AlGaN P-gate 3200 structure.

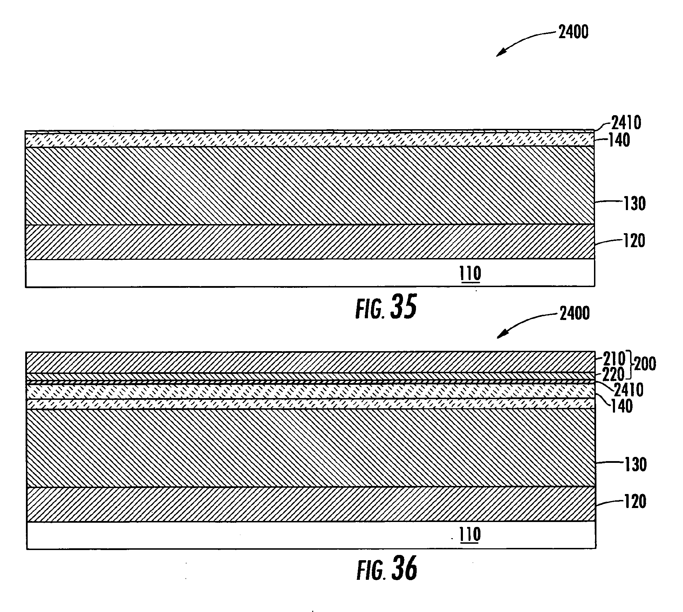

In another embodiment shown in FIGS. 35-41, AlN is used as a thin cap layer over the AlGaN layer. FIG. 35 shows a similar structure as that of FIG. 24, but the AlN layer 2410 is in the range of about 5Å to about 100Å, preferably about 10Å to about 20 Å.

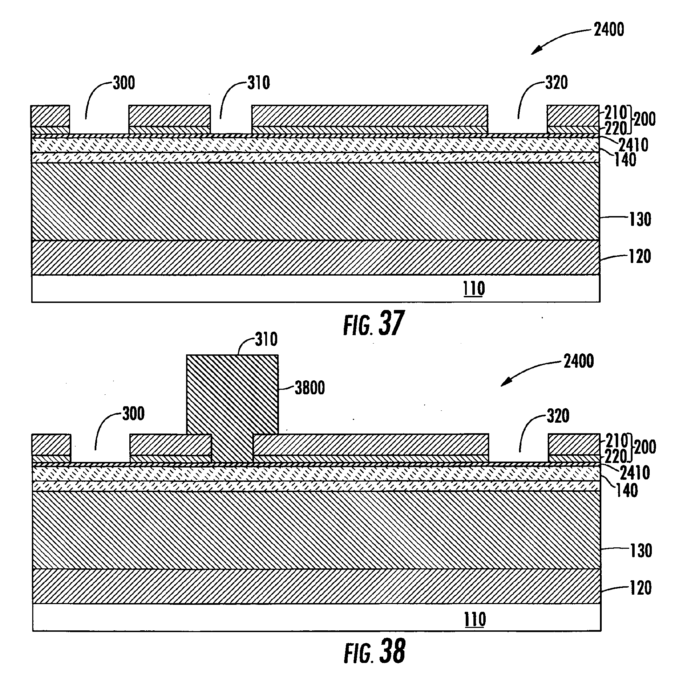

In the embodiment shown, a dielectric stack 200 can then be deposited using known oxide and nitride deposition techniques. The dielectric stack 200 can include one or more dielectric layers, for example, a first dielectric layer 220 including, e.g., nitride, oxide, oxynitride, etc., and a second dielectric layer 210 including an undensified oxide. The dielectric stack 200 can be blanket deposited over the AlGaN layer 140. The dielectric stack 200 can be patterned by, for example, a contact mask (not shown), that can be used to define a source contact area 300, a gate contact area 310, and a drain contact area 320. An advantage to this process is that a single masking step is used to self-align the gate contact area to the source contact area 300 and the drain contact area 320. By using a single masking step, precise control of the gate-source and gate-drain spacing can be obtained. The resulting structure is shown in FIG. 37, in which the three defined areas (300, 310, 320) can be etched to remove the dielectric stack 200 to expose a surface of the AlN layer 2410.

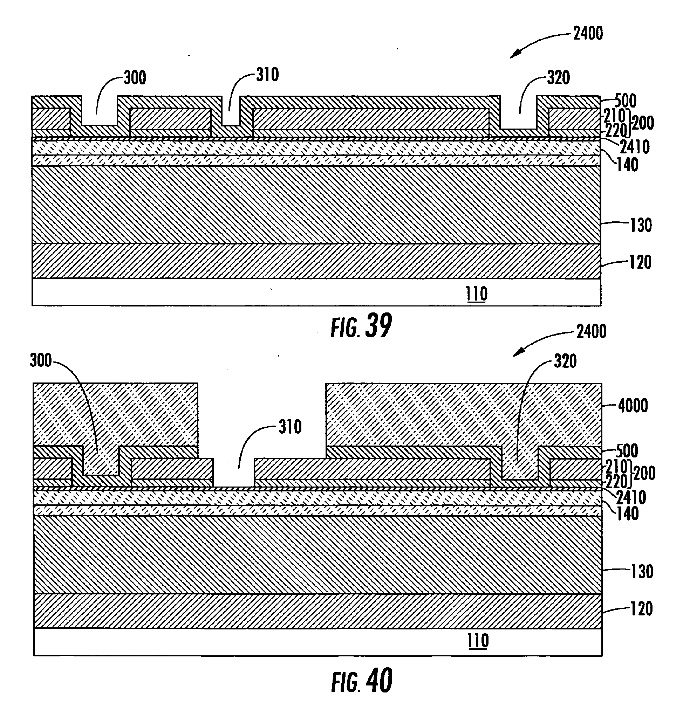

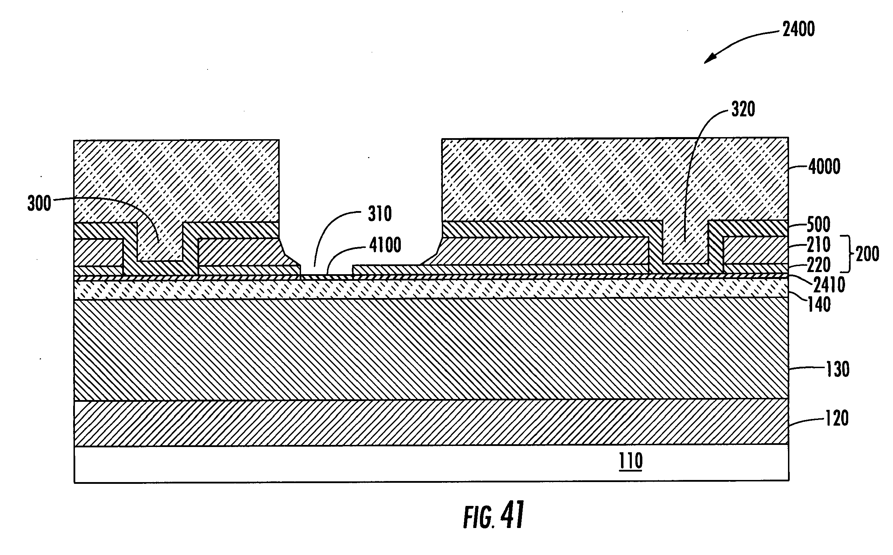

FIG. 38 shows an optional gate protection mask 3800. An optional N+ implant 400 can be performed using the gate protection mask 3800. A resist strip can be performed to remove the gate protection mask 3800 and an anneal at about 1100oC to about 1300oC in nitrogen ambient can be performed to further drive in the N+ implant. In FIG. 39, a dielectric layer 500 (e.g., plasma silicon nitride) can be deposited conformally over the patterned dielectric stack 200 and the exposed portions of the AlN layer 2410. The dielectric layer 500 can be deposited using LPCVD. As shown in FIG. 40, a mask 4000 can be formed to expose the defined gate contact area 310. A first dry etch can be used to selectively etch the dielectric layer 500 in the defined gate contact area 310. The first dry etch can be selective to AlN and dielectric stack 200. Following the first dry etch, a second etch that is selective to the dielectric layer 220 and the dielectric layer 500 can be performed (no under-cut of the dielectric layer 500 is shown in this embodiment). The second etch can also thin the thin AlN layer 2410. The resulting structure is shown in FIG. 41, which shows the gate contact area 310 including an exposed portion of the thinned AlN layer 2410 having approximately straight sidewalls formed from the dielectric layer 220 and an approximately wider bowl shaped area formed in the dielectric layer 210, with no under-cutting under the dielectric layer 500.

Following resist strip (not shown), the thinned AlN layer 2410 can be oxidized to create an Al2O3 insulator 4100 in the exposed gate contact area. The oxidation can be performed by rapid temperature anneal (RTA), other thermal processes, and/or by plasma enhanced processes. While no specific theory has been proven, it is believed that the formation of the Al203 insulator 4100 enhances adhesion between the metallization and the AlGaN layer 140.

It will be evident to one of ordinary skill in the art that the processes and resulting structures previously described can be modified to form various semiconductor device features having different patterns, widths, and/or materials using a single mask step. Exemplary methods and resulting structures are described below.

Notwithstanding that the numerical ranges and parameters setting forth the broad scope of the present teachings are approximations, the numerical values set forth in the specific examples are reported as precisely as possible. Any numerical value, however, inherently contains certain errors necessarily resulting from the standard deviation found in their respective testing measurements. Moreover, all ranges disclosed herein are to be understood to encompass any and all sub-ranges subsumed therein. For example, a range of "less than 10" can include any and all sub-ranges between (and including) the minimum value of zero and the maximum value of 10, that is, any and all sub-ranges having a minimum value of equal to or greater than zero and a maximum value of equal to or less than 10, e.g., 1 to 5. In certain cases, the numerical values as stated for the parameter can take on negative values. In this case, the example value of range stated as "less that 10" can assume negative values, e.g. - 1, -2, -3, -10, -20, -30, etc.

While the present teachings have been illustrated with respect to one or more implementations, alterations and/or modifications can be made to the illustrated examples without departing from the spirit and scope of the appended claims. In addition, while a particular feature of the present disclosure may have been described with respect to only one of several implementations, such feature may be combined with one or more other features of the other implementations as may be desired and advantageous for any given or particular function. Furthermore, to the extent that the terms "including," "includes," "having," "has," "with," or variants thereof are used in either the detailed description and the claims, such terms are intended to be inclusive in a manner similar to the term "comprising." The term "at least one of" is used to mean one or more of the listed items can be selected. As used herein, the term "one or more of" with respect to a listing of items such as, for example, A and B or A and/or B, means A alone, B alone, or A and B. The term "at least one of" is used to mean one or more of the listed items can be selected. Further, in the discussion and claims herein, the term "on" used with respect to two materials, one "on" the other, means at least some contact between the materials, while "over" means the materials are in proximity, but possibly with one or more additional intervening materials such that contact is possible but not required. Neither "on" nor "over" implies any directionality as used herein. The term "conformal" describes a coating material in which angles of the underlying material are preserved by the conformal material. The term "about" indicates that the value listed may be somewhat altered, as long as the alteration does not result in nonconformance of the process or structure to the illustrated embodiment. Finally, "exemplary" indicates the description is used as an example, rather than implying that it is an ideal. Other embodiments of the present teachings will be apparent to those skilled in the art from consideration of the specification and practice of the methods and structures disclosed herein. It is intended that the specification and examples be considered as exemplary only, with a true scope and spirit of the present teachings being indicated by the following claims.

Terms of relative position as used in this application are defined based on a plane parallel to the conventional plane or working surface of a wafer or substrate, regardless of the orientation of the wafer or substrate. The term "horizontal" or "lateral" as used in this application is defined as a plane parallel to the conventional plane or working surface of a wafer or substrate, regardless of the orientation of the wafer or substrate. The term "vertical" refers to a direction perpendicular to the horizontal. Terms such as "on," "side" (as in "sidewall"), "higher," "lower," "over," "top," and "under" are defined with respect to the conventional plane or working surface being on the top surface of the wafer or substrate, regardless of the orientation of the wafer or substrate.

A further method of manufacturing an enhanced mode (e-mode) high electron mobility transistor (HEMT) of the invention comprises: forming a first compound semiconductor layer over a surface of a substrate; forming a second compound semiconductor layer over a surface of the first compound semiconductor layer opposite the substrate surface; forming a first dielectric over a surface of the second compound semiconductor layer opposite the surface of the first compound semiconductor; defining a source contact area, a drain contact area, and a gate contact area, through the first dielectric using one mask layer to expose portions of the second compound semiconductor layer; forming a second dielectric conformally over the first dielectric and the exposed portions of the second compound semiconductor layer; etching the second dielectric to expose the gate area; isotropically etching the first dielectric exposed in the gate contact area to form an etched area; growing epitaxial p-type second compound semiconductor on the exposed gate contact area to substantially fill the etched gate contact area and to cover at least a portion of the etched area of the first dielectric.
Preferably, the method of the invention further comprises: masking the second dielectric to define the gate contact area. Preferably, in the method of the invention masking further defines a field plate area. Preferably, in the method of the invention etching the second dielectric further defines a lateral extension of an integrated field plate area.
Preferably, the method of the invention further comprises: growing the epitaxial p- type second compound semiconductor to substantially fill the etched first dielectric area and to cover at least a portion of the second dielectric. Preferably, the method of the invention further comprises: forming an ohmic source contact over the source contact area; forming an ohmic drain contact over the drain contact area; and forming a Schottky metal over at least a portion of the epitaxial p- type second compound semiconductor.
Preferably, in the method of the invention the formed ohmic source contact further forms a field plate. Preferably, in the method of the invention the formed Schottky metal further forms a field plate.
Preferably, in the method of the invention etching the second dielectric to expose the gate contact area further comprises: recess etching at least a portion of the gate contact area through at least a portion of the second compound semiconductor layer.
Preferably, in the method of the invention the first compound semiconductor comprises GaN. Preferably, in the method of the invention the substrate is selected from silicon, sapphire, silicon carbide, indium phosphide, diamond, silicon on diamond, and sapphire on diamond.
Preferably, the method of the invention further comprises: forming an AlGaN layer between the surface of the substrate and the first compound semiconductor layer. Preferably, in the method of the invention the second compound semiconductor layer comprises at least one of AlGaN, GaN, InP, and InAlN.
Preferably, in the method of the invention forming the second compound semiconductor layer, further comprises: forming a compound semiconductor stack comprising at least two different compound semiconductors layers.
Preferably, in the method of the invention the semiconductor stack comprises an AlGaN layer and an AlN layer. Preferably, in the method of the invention the first dielectric comprises a stack of dielectric layers.
Preferably, in the method of the invention the forming the second dielectric further includes: forming a plasma nitride as the second dielectric layer. Preferably, the method of the invention further comprises: forming a cap layer between the first dielectric layer and the second compound semiconductor layer, wherein the cap layer comprises a GaN layer.
Preferably, in the method of the invention forming the first dielectric further comprises forming multiple dielectric layers. Preferably, the method of the invention further comprises: forming an AlGaN layer between the substrate and the first compound layer.

A further method of manufacturing an enhanced mode (e-mode) high electron mobility transistor (HEMT) of the invention comprises: forming a GaN layer over a surface of a substrate; forming a III-V semiconductor layer over a surface of the GaN layer opposite the substrate surface; forming an AlN semiconductor layer between the III-V semiconductor layer and a first dielectric; forming the first dielectric over a surface of the AlN semiconductor layer opposite the surface of the III-V semiconductor layer; defining a source contact area, a drain contact area, and a gate contact area, through the first dielectric using one mask layer to expose the AlN semiconductor layer; forming a second dielectric conformally over the first dielectric and the exposed portions of the AlN semiconductor layer; etching the second dielectric to expose the AlN in the defined gate contact area; and growing epitaxial p- type III-V semiconductor over the exposed gate contact area to substantially fill the etched gate contact area and to cover at least a portion of the etched first dielectric area.
Preferably, the method of the invention further comprises: oxidizing the exposed AlN in the defined gate contact area to form a thin aluminum oxide layer; and growing epitaxial p-type III-V semiconductor on the thin aluminum oxide layer in the defined gate contact area to substantially fill the defined gate area
Preferably, in the method of the invention oxidizing the exposed AlN further comprises: forming a thin oxidation layer of about 5Å to about 120Å. Preferably, in the method of the invention the thin oxidation layer is about 10Å to about 20Å.
Preferably, in the method of the invention oxidizing the exposed AlN further comprises: applying an oxidizing process selected from the group consisting of thermal oxidation, rapid thermal anneal, and plasma enhanced oxidation. Preferably, the method of the invention further comprises: growing the epitaxial p- type III-V semiconductor through at least a portion of the second dielectric. Preferably, the method of the invention further comprises: masking the second dielectric to define the gate contact area.
Preferably, in the method of the invention masking further defines a field plate area. Preferably, in the method of the invention etching the second dielectric further defines a lateral extension of an integrated field plate area. Preferably, the method of the invention further comprises: growing the epitaxial p- type III-V semiconductor to substantially fill the etched first dielectric area and to cover at least a portion of the second dielectric.
Preferably, the method of the invention further comprises: forming an ohmic source contact over the source contact area; forming an ohmic drain contact over the drain contact area; and forming a Schottky metal over at least a portion of the epitaxial p- type III-V semiconductor.
Preferably, in the method of the invention the formed ohmic source contact further forms a field plate. Preferably, in the method of the invention the formed Schottky metal further forms a field plate.
Preferably, in the method of the invention etching the second dielectric to expose the gate contact area further comprises: recess etching at least a portion of the gate contact area through at least a portion of the III-V semiconductor layer. Preferably, in the method of the invention the substrate is selected from silicon, sapphire, silicon carbide, diamond, silicon on diamond, and sapphire on diamond. Preferably, the method of the invention further comprises: forming an AlGaN layer between the surface of the substrate and the GaN layer.
Preferably, in the method of the invention the III-V semiconductor layer comprises at least one of AlGaN, GaN, and InAlN.Preferably, in the method of the invention the first dielectric comprises a stack of dielectric layers.
Preferably, in the method of the invention the forming the second dielectric further includes: forming a plasma nitride as the second dielectric layer. Preferably, the method of the invention further comprises: forming a cap layer between the first dielectric layer and the III-V semiconductor layer, wherein the cap layer comprises a GaN layer.
Preferably, the method of the invention further comprises: forming an AlGaN layer between the substrate and the GaN layer. Preferably, in the method of the invention forming the first dielectric further comprises forming multiple dielectric layers.

A further method of manufacturing an enhanced mode (e-mode) high electron mobility transistor (HEMT) of the invention comprises: forming a first compound semiconductor layer over a surface of a substrate; forming a second compound semiconductor layer over a surface of the first compound semiconductor layer opposite the substrate surface; forming a third compound semiconductor layer between the second compound semiconductor layer and a first dielectric; forming the first dielectric over a surface of the third compound semiconductor layer opposite the surface of the second semiconductor layer; defining a source contact area, a drain contact area, and a gate contact area, through the first dielectric using one mask layer to expose the AlN semiconductor layer; forming a second dielectric conformally over the first dielectric and the exposed portions of the third compound semiconductor layer; etching the second dielectric and a portion of the first dielectric to expose the third compound semiconductor in the defined gate contact area; and growing epitaxial p-type second compound semiconductor over the exposed gate contact area to substantially fill the etched gate contact area and to cover at least a portion of the etched first dielectric area.

A further method of manufacturing an enhanced mode (e-mode) high electron mobility transistor (HEMT) of the invention comprises: forming a GaN layer over a surface of a substrate; forming a III-V semiconductor layer over a surface of the GaN layer opposite the substrate surface; forming an AlN semiconductor layer between the III-V semiconductor layer and a first dielectric; forming the first dielectric over a surface of the AlN semiconductor layer opposite the surface of the III-V semiconductor layer; defining a source contact area, a drain contact area, and a gate contact area, through the first dielectric using one mask layer to expose the AlN semiconductor layer; forming a second dielectric conformally over the first dielectric and the exposed portions of the AlN semiconductor layer; etching the second dielectric and a portion of the first dielectric to expose the AlN in the defined gate contact area; and growing epitaxial p-type III-V semiconductor over the exposed gate contact area to substantially fill the etched gate contact area and to cover at least a portion of the etched first dielectric area.

## Claims

1. A method of manufacturing an enhancement mode (e-mode) high electron mobility transistor (HEMT), comprising:
forming a first compound semiconductor layer over a surface of a substrate;
forming a second compound semiconductor layer over a surface of the first compound semiconductor layer opposite the substrate surface;
forming a first dielectric over a surface of the second compound semiconductor layer opposite the surface of the first compound semiconductor;
defining a source contact area, a drain contact area, and a gate contact area, through the first dielectric using one mask layer to expose portions of the second compound semiconductor layer;
forming a second dielectric conformally over the first dielectric and the exposed portions of the second compound semiconductor layer;
etching the second dielectric to expose the gate area;
isotropically etching the first dielectric exposed in the gate contact area to form an etched area;
growing epitaxial p-type second compound semiconductor on the exposed gate contact area to substantially fill the etched gate contact area and to cover at least a portion of the etched area of the first dielectric.

2. The method of claim 1, further comprising: masking the second dielectric to define the gate contact area.

3. The method of claim 2, wherein masking further defines a field plate area.

4. The method of claim 1, wherein etching the second dielectric further defines a lateral extension of an integrated field plate area.

5. The method of claim 1, further comprising:
growing the epitaxial p-type second compound semiconductor to substantially fill the etched first dielectric area and to cover at least a portion of the second dielectric.

6. The method of claim 1, further comprising: forming an ohmic source contact over the source contact area; forming an ohmic drain contact over the drain contact area; and forming a Schottky metal over at least a portion of the epitaxial p-type second compound semiconductor.

7. The method of claim 6, wherein the formed ohmic source contact further forms a field plate.

8. The method of claim 6, wherein the formed Schottky metal further forms a field plate.

9. The method of claim 1, wherein etching the second dielectric to expose the gate contact area further comprises:
recess etching at least a portion of the gate contact area through at least a portion of the second compound semiconductor layer.

10. The method of claim 1, wherein the first compound semiconductor comprises GaN.

11. The method of claim 1, wherein the substrate is selected from silicon, sapphire, silicon carbide, indium phosphide, diamond, silicon on diamond, and sapphire on diamond.

12. The method of claim 1, further comprising: forming an AlGaN layer between the surface of the substrate and the first compound semiconductor layer.

13. The method of claim 1, wherein the second compound semiconductor layer comprises at least one of AlGaN, GaN, InP, and InAlN.

14. The method of claim 1, wherein forming the second compound semiconductor layer, further comprises:
forming a compound semiconductor stack comprising at least two different compound semiconductors layers.

15. The method of claim 14, wherein the semiconductor stack comprises an AlGaN layer and an AlN layer.

16. The method of claim 1, wherein the forming the second dielectric further includes:
forming a plasma nitride as the second dielectric layer.

17. The method of claim 1, further comprising: forming a cap layer between the first dielectric layer and the second compound semiconductor layer, wherein the cap layer comprises a GaN layer.

18. The method of claim 1, wherein forming the first dielectric further comprises: forming multiple dielectric layers.

19. A method of manufacturing an enhancement mode (e-mode) high electron mobility transistor (HEMT), comprising:
forming a first compound semiconductor layer over a surface of a substrate;
forming a second compound semiconductor layer over a surface of the first compound semiconductor layer opposite the substrate surface;
forming a third compound semiconductor layer between the second compound semiconductor layer and a first dielectric;
forming the first dielectric over a surface of the third compound semiconductor layer opposite the surface of the second semiconductor layer;
defining a source contact area, a drain contact area, and a gate contact area, through the first dielectric using one mask layer to expose the AIN semiconductor layer;
forming a second dielectric conformally over the first dielectric and the exposed portions of the third compound semiconductor layer;
etching the second dielectric and a portion of the first dielectric to expose the third compound semiconductor in the defined gate contact area and
growing epitaxial p-type second compound semiconductor over the exposed gate contact area to substantially fill the etched gate contact area and to cover at least a portion of the etched first dielectric area.

## Patentansprüche

1. Verfahren zum Herstellen eines Anreicherungsmodus- (E-Modus-) -Transistors mit hoher Elektronenbeweghchkeit (HEMT), umfassend:
Bilden einer ersten Verbindungshalbleiterschicht über einer Oberfläche eines Substrats;
Bilden einer zweiten Verbindungshalbleiterschicht über einer Oberfläche der ersten Verbindungshalbleiterschicht gegenüber der Substratoberfläche;
Bilden eines ersten Dielektrikums über einer Oberfläche der zweiten Verbindungshalbleiterschicht gegenüber der Oberfläche des ersten Verbindungshalbleiters;
Bestimmen eines Source-Konfaktbereichs, eines Drain-Kontaktbereichs und eines Gate-Kontaktbereichs durch das erste Dielektrikum unter Verwendung einer Maskenschicht,
um Abschnitte der zweiten Verbindungshalbleiterschicht freizulegen;
Bilden eines zweiten Dielektrikums konform über dem ersten Dielektrikum und den freigelegten Abschnitten der zweiten Verbindungshalbleiterschicht;
Ätzen des zweiten Dielektrikums, um den Gate-Bereich freizulegen;
isotropes Ätzen des in dem Gate-Kontaktbereich freigelegten ersten Dielektrikums, um einen geätzten Bereich zu bilden;
Aufwachsen eines epitaktischen zweiten Verbindungshalbleiters vom p-Typ auf dem freigelegten Gate-Kontaktbereich, um den geätzten Gate-Kontaktberetch im Wesentlichen zu füllen und um wenigstens einen Abschnitt des geätzten Bereichs des ersten Dielektrikum abzudecken.

2. Verfahren gemäß Anspruch 1, weiterhin umfassend: Maskieren des zweiten Dielektrikums, um den Gate-Kontaktbereich zu bestimmen.

3. Verfahren gemäß Anspruch 2, wobei das Maskieren weiterhin einen Feldplattenbereich bestimmt.

4. Verfahren gemäß Anspruch 1, wobei das Ätzen des zweiten Dielektrikums weiterhin eine laterale Ausdehnung eines integrierten Feldplattenbereichs bestimmt.

5. Verfahren gemäß Anspruch 1, weiterhin umfassend:
Aufwachsen des epitaktischen zweiten Verbindungshalbleiters vom p-Typ, um den geätzten ersten Dielektrikumsbereich im Wesentlichen zu füllen und um wenigstens einen Abschnitt des zweiten Dielektrikums abzudecken.

6. Verfahren gemäß Anspruch 1, weiterhin umfassend: Bilden eines ohmschen Source-Kontakts über dem Source-Kontaktbereich; Bilden eines ohmschen Drain-Kontakts über dem Drain-Kontaktbereich und Bilden eines Schottky-Metalls über zumindest einem Abschnitt des epitaktischen zweiten Verbindungshalbleiters vom p-Typ.

7. Verfahren gemäß Anspruch 6, wobei der gebildete ohmsche Source-Kontakt weiterhin eine Feldplatte bildet.

8. Verfahren gemäß Anspruch 6, wobei das gebildete Schottky-Metall weiterhin eine Feldplatte bildet.

9. Verfahren gemäß Anspruch 1, wobei das Ätzen des zweiten Dielektrikums, um den Gate-Kontaktbereich freizulegen, weiterhin umfasst:
Ausnehmungsätzen wenigstens eines Abschnitts des Gate-Kontaktbereichs durch wenigstens einen Abschnitt der zweiten Verbindungshalbleiterschicht.

10. Verfahren gemäß Anspruch 1, wobei der erste Verbindungshalbleiter GaN umfasst.

11. Verfahren gemäß Anspruch 1, wobei das Substrat aus Silicium, Saphir, Siliciumcarbid, Indiumphosphid, Diamant, Silicium auf Diamant und Saphir auf Diamant ausgewählt ist.

12. Verfahren gemäß Anspruch 1, weiterhin umfassend: Bilden einer AlGaN-Schicht zwischen der Oberfläche des Substrats und der ersten Verbindungshalbleiterschicht.

13. Verfahren gemäß Anspruch 1, wobei die zweite Verbindungshalbleiterschicht wenigstens eines von AlGaN, GaN, InP und InAlN umfasst.

14. Verfahren gemäß Anspruch 1, wobei das Bilden der zweiten Verbindungshalbleiterschicht weiterhin umfasst:
Bilden eines Verbindungshalbleiterstapels, der wenigstens zwei verschiedene Verbindungshalbleiterschichten umfasst.

15. Verfahren gemäß Anspruch 14, wobei der Halbleiterstapel eine AlGaN-Schicht und eine AlN-Schicht umfasst.

16. Verfahren gemäß Anspruch 1, wobei das Bilden des zweiten Dielektrikums weiterhin aufweist:
Bilden eines Plasmanitrids als die zweite dielelctrische Schicht.

17. Verfahren gemäß Anspruch 1, weiterhin umfassend: Bilden einer Deckschicht zwischen der ersten dielektrischen Schicht und der zweiten Verbindungshalbleiterschicht, wobei die Deckschicht eine GaN-Schicht umfasst.

18. Verfahren gemäß Anspruch 1, wobei das Bilden des ersten Dielektrikums weiterhin umfasst: Bilden mehrerer dielektrischer Schichten.

19. Verfahren zum Herstellen eines Anreicherungsmodus- (E-Modus) -Transistors mit hoher Elektronenbeweglichkeit (HEMT), umfassend:
Bilden einer ersten Verbindungshalbleiterschicht über einer Oberfläche eines Substrats;
Bilden einer zweiten Verbindungshalbleiterschicht über einer Oberfläche der ersten Verbindungshalbleiterschicht gegenüber der Substratoberfläche,
Bilden einer dritten Verbindungshalbleiterschicht zwischen der zweiten Verbindungshalbleiterschicht und einem ersten Dielektrikum;
Bilden des ersten Dielektrikums über einer Oberfläche der dritten Verbindungshalbleiterschicht gegenüber der Oberfläche der zweiten Halbleiterschicht;
Bestimmen eines Source-Kontaktbereichs, eines Drain-Kontaktbereichs und eines Gate-Kontaktbereichs durch das erste Dielektrikum unter Verwendung einer Maslcenschicht,
um die AlN-Halbleiterschicht freizulegen;
Bilden eines zweiten Dielektrikums konform über dem ersten Dielektrikum und den freigelegten Abschnitten der dritten Verbindungshalbleiterschicht;
Ätzen des zweiten Dielektrikums und eines Abschnitts des ersten Dielektrikums, um den dritten Verbindungshalbleiter in dem bestimmten Gate-Kontaktbereich freizulegen, und
Aufwachsen eines epitaktischen zweiten Verbindungshalbleiters vom p-Typ über dem freigelegten Gate-Kontaktbereich, um den geätzten Gate-Kontaktbereich im Wesentlichen zu füllen und um wenigstens einen Abschnitt des geätzten ersten Dielektrikumsbereichs abzudecken.

## Revendications

1. Méthode de fabrication d'un transistor à haute mobilité d'électrons (HEMT) à mode d'enrichissement (mode e) comprenant :
la formation d'une première couche de semi-conducteur composé sur une surface d'un substrat ;
la formation d'une seconde couche de semi-conducteur composé sur une surface de la première couche de semi-conducteur composé opposée à la surface de substrat ;
la formation d'un premier diélectrique sur une surface de la seconde couche de semi-conducteur composé opposée à la surface du premier semi-conducteur composé ;
la définition d'une zone de contact source, d'une zone de contact de désamorçage, et d'une zone de contact de portillon, par le premier diélectrique en utilisant une couche de masque pour mettre en vue des parties de la seconde couche de semi-conducteur composé ;
la formation d'un second diélectrique conformément via la premier diélectrique et les parties mises en vue de la seconde couche de semi-conducteur composé ;
la gravure du second diélectrique pour mettre en vue la zone de portillon ;
la gravure isotrope du premier diélectrique exposé dans la zone de contact de portillon pour constituer une zone gravée ;
la production d'un second semi-conducteur composé de type p épitaxial sur la zone exposée de contact de portillon pour remplir de manière importante la zone de contact de portillon gravée et pour couvrir au moins une partie de la zone gravée du premier diélectrique.

2. Méthode selon la revendication 1, comprenant par ailleurs : le masquage du second diélectrique pour définir la zone de contact de portillon.

3. Méthode selon la revendication 2, dans laquelle le masquage définit par ailleurs une zone de plaque de champ.

4. Méthode selon la revendication 1, dans laquelle la gravure du second diélectrique définit par ailleurs une extension latérale d'une zone de plaque de champ intégrée.

5. Méthode selon la revendication 1, comprenant par ailleurs : la production du second semi-conducteur composé de type p épitaxial pour remplir de manière importante la première zone diélectrique gravée et pour couvrir au moins une partie de la second diélectrique.

6. Méthode selon la revendication 1, comprenant par ailleurs : la formation d'un contact source ohmique via la zone de contact source ; la formation d'un contact de désamorçage ohmique via la zone de contact de désamorçage ; et la formation d'un métal de Schottky via au moins une

7. Méthode selon la revendication 6, dans laquelle le contact source ohmique formé constitue par ailleurs une plaque de champ.

8. Méthode selon la revendication 6, dans laquelle le métal de Schottky formé constitue par ailleurs une plaque de champ.

9. Méthode selon la revendication 1, dans laquelle la gravure du second diélectrique pour mettre en vue la zone de contact de portillon comprend par ailleurs : la gravure cruciforme d'au moins une partie de la zone de contact de portillon par au moins une partie de la seconde couche de semi-conducteur composé.

10. Méthode selon la revendication 1, dans laquelle le premier semi-conducteur composé comprend du GaN.

11. Méthode selon la revendication 1, dans laquelle le substrat est sélectionné à partir du silicium, du saphir, du carbure de silicium, du phosphure d'indium, du diamant, du silicium sur du diamant, et du saphir sur du diamant.

12. Méthode selon la revendication 1, comprenant par ailleurs : la formation d'une couche d'AlGaN entre la surface du substrat et la première couche de semi-conducteur composé.

13. Méthode selon la revendication 1, dans laquelle la seconde couche de semi-conducteur composé comprend au moins un des composés AlGaN, GaN, InP, et InAlN.

14. Méthode selon la revendication 1, dans laquelle la formation de la seconde couche de semi-conducteur composé, comprend par ailleurs : la formation d'un bloc semi-conducteur composé comprenant au moins deux couches différentes de semi-conducteurs composés.

15. Méthode selon la revendication 14, dans laquelle bloc semi-conducteur comprend une couche d'AlGaN et une couche d'AlN.

16. Méthode selon la revendication 1, dans laquelle la formation du second diélectrique comporte par ailleurs : la formation d'un nitrure au plasma comme seconde couche diélectrique.

17. Méthode selon la revendication 1, comprenant par ailleurs : la formation d'une couche de couronnement entre la première couche diélectrique et la seconde couche de semi-conducteur composé, dans laquelle la couche de couronnement comprend une couche de GaN.

18. Méthode selon la revendication 1, dans laquelle la formation du premier diélectrique comprend par ailleurs : la formation de plusieurs couches diélectriques.

19. Méthode de fabrication d'un transistor à haute mobilité d'électrons (HEMT) à mode d'enrichissement (mode e) comprenant :
la formation d'une première couche de semi-conducteur composé sur une surface d'un substrat ;
la formation d'une seconde couche de semi-conducteur composé sur une surface de la première couche de semi-conducteur composé opposée à la surface de substrat ;
la formation d'une troisième couche de semi-conducteur composé entre la seconde couche de semi-conducteur composé et un premier diélectrique ;
la formation du premier diélectrique sur une surface de la troisième couche de semi-conducteur composé opposée à la surface de la seconde couche de semi-conducteur ;
la définition d'une zone de contact source, d'une zone de contact de désamorçage, et d'une zone de contact de portillon, par le premier diélectrique en utilisant une couche de masque pour mettre en vue la couche de semi-conducteur AIN ;
la formation d'un second diélectrique conformément via la premier diélectrique et les parties mises en vue de la troisième couche de semi-conducteur composé ;
la gravure du second diélectrique et une partie du premier diélectrique pour mettre en vue le troisième semi-conducteur composé dans la zone de contact de portillon définie et
la production d'un second semi-conducteur composé de type p épitaxial via la zone exposée de contact de portillon pour remplir de manière importante la zone de contact de portillon gravée et pour couvrir au moins une partie de la première zone diélectrique gravée.
